# EUROPEAN PATENT APPLICATION

(11) **EP 1 239 595 A2**
(43) Date of publication of application: **11.09.2002**
(21) Application number: 02090104.7
(22) Date of filing: 11.03.2002
(51) Int. Cl.: H03M 13/09

(54) **Packet based ATM CRC-32 calculator**

(30) Priority: 09.03.2001 US 275155 P
(71) Applicant: Vitesse Semiconductor Corporation, Camarillo, California 93012 (US)
(72) Inventor: Onvural, O. Raif, Cary, North Carolina 27511 (US); Mudoi, Uday, Morrisville, North Carolina 27560 (US)
(74) Representative: Baumgärtel, Gunnar, Dr.

(57) **Abstract**

A method and apparatus for detecting errors in a data packet being transmitted as a set of smaller data cells by performing operations on the Cyclic Redundancy Check (CRC) values of the individual cells. An error detection apparatus initializes a memory area with a first value. The apparatus generates a CRC value for a first data cell. The apparatus combines the first value and the CRC value for the first cell in a XOR operation and the apparatus stores the result in a memory location. For subsequent cells in the data packet, the apparatus generates a cell CRC value, shifts the value in the memory location twelve times, and replaces the shifted value in the memory location with a new value generated from a XOR operation performed on the shifted value and the cell CRC value. The apparatus compares the final value in the memory location with an end comparison value and generates an error signal if the final and comparison values are different.

## Description

### BACKGROUND OF THE INVENTION

This invention relates generally to communications networks, and more specifically to communications networks transmitting data packets.

Communications networks often transfer data between applications residing on different nodes of the network. The transmitted data is often of variable length. Some communication network protocols, however, call for the transmission of data packets in cells comprised of fixed length packets. For example, Asynchronous Transfer Mode (ATM) networks in accordance with ATM Adaption Layer 5 (AAL5) generally transmit cells of 53 bytes, with a 5 byte header and a 48 byte payload. In operation, a variable length message provided by an application is broken, or segmented, into a number of ATM cells.

The variable length message is sometimes termed a Protocol Data Unit (PDU), and the ATM cells forming the message is sometimes referred to as an AAL5 Common Part Convergence Sublayer (CPCS) PDU. The last cell of AAL5 CPCS PDU includes a trailer. The trailer forms the last 8 bytes of the payload of the last cell. The last 4 bytes of the trailer is a 32 bit Cyclic Redundancy Check (CRC) value. The CRC value pertains to the entire PDU.

The CRC is used for error detection in the payload. The CRC is generated by combining, generally using polynomial division, the binary value of the PDU with another binary value, generally termed a polynomial. For ATM processing the polynomial generally used is x³² + x²⁶ +x²³ + x²² + x¹⁶ + x¹² + x¹¹ + x¹⁰ + x⁸ + x⁷ + x⁵ + x⁴ + x² + x + 1. The remainder after the entire PDU has been processed using polynomial division is the CRC value. On receipt by a receiving node the CRC value is recalculated in order to determine if errors occurred in transmission of the PDU.

At the receiving node, calculation of the CRC value can be resource intensive. This may be particularly true if a node is receiving multiple messages from multiple nodes over the same time period. In such a circumstance, during the course of reception of cells from a particular PDU, the node may also receive cells from numerous other PDUs. CRC values are calculated for each PDU. Thus, if calculating CRC values on reception, the node potentially will require CRC evaluators for each PDU being received at a given time. As cells for numerous PDUs may be received at any given time, such an implementation may be costly, particularly with respect to area and power in hardware implementations. Alternatively, a node may wait for reception of all of the cells forming a PDU, and then perform CRC calculations for the PDU. This reduces the need for multiple CRC evaluators, but possibly requires storage of cells forming the PDU. Such a solution may unnecessarily increase storage requirements of a node.

### SUMMARY OF THE INVENTION

Errors are detected in a data packet being transmitted as a set of smaller data cells by performing operations on the Cyclic Redundancy Check (CRC) values of the individual cells. An error detection apparatus initializes a memory area with a first value. The apparatus generates a CRC value for a first data cell. The apparatus combines the first value and the CRC value for the first cell in a XOR operation and the apparatus stores the result in the memory location.

For subsequent cells in the data packet, the apparatus generates a cell CRC value, shifts the value in the memory location twelve times, and replaces the shifted value in the memory location with a new value generated from a XOR operation performed on the shifted value and the cell CRC value.

The apparatus compares the final value in the memory location with an end comparison value and generates an error signal if the final and comparison values are different.

In one aspect of the invention, an error detection apparatus is provided that comprises a high speed interface, a segmentation module and a reassembly module. The high speed interface calculates a cyclic redundancy check value for incoming data. The segmentation module divides higher layer cells into lower layer cells and calculating intermediate CRC values for each lower layer cell. The reassembly module generates higher layer cells from lower layer cells and calculating intermediate CRC values for each of the lower layer cells. In another aspect of the invention, a register is provided where the high speed interface initializes the register with a predetermined value.

### BRIEF DESCRIPTION OF THE DRAWINGS

These and other features, aspects and advantages of the present invention will be more fully understood when considered with regard to the following detailed description, appended claims and accompanying drawings wherein:
FIG. 1 is a diagram of a system in accordance with aspects of the present invention;
FIG. 2 is a flow diagram in accordance with the present invention;
FIG. 3 is a diagram depicting a AAL5 CPCS PDU used within an AAL5;
FIG. 4 is a diagram of an ATM cell;
FIG. 5 is an exemplary system implementing the reassembly error checking process described in FIG. 2; and
FIGS. 6 and 7 depict a process flow diagram of an exemplary process for calculating a CRC value while segmenting a higher layer PDU into an AAL5 CPCS PDU.

### DETAILED DESCRIPTION OF THE INVENTION

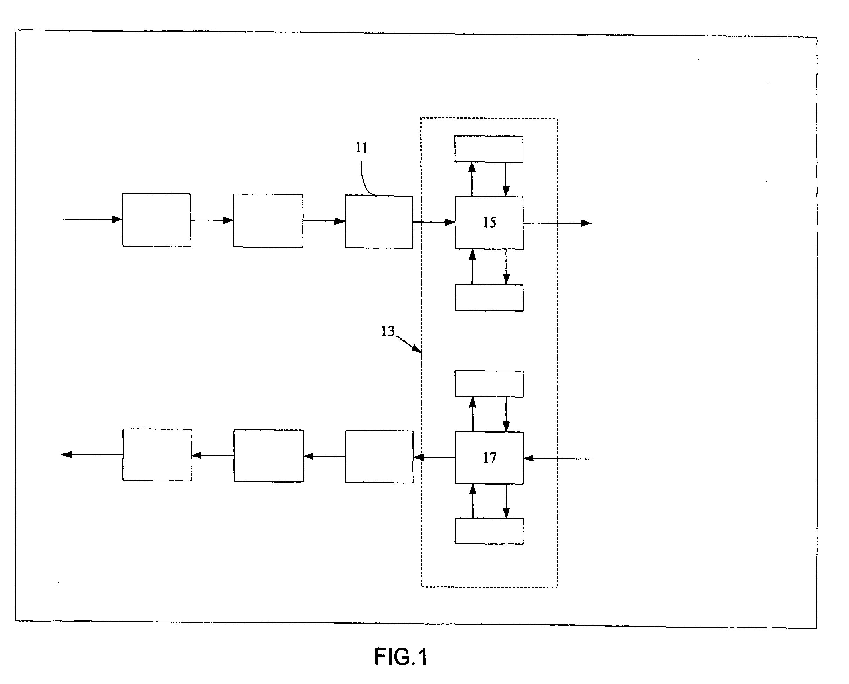

FIG. 1 illustrates a block diagram of elements of a node in accordance with aspects of the present invention. The node is adapted to perform operations with respect to the receipt and transmission of Asynchronous Transfer Mode (ATM) cell traffic.

The node includes a high speed interface (HSI) 11 for reception of ATM cells. The high speed interface provides the ATM cells to a Segmentation and Reassembly (SAR) module 13. The SAR module includes a reassembly component 15. The reassembly module or component reassembles the received ATM cells into AAL5 CPCS PDUs. The AAL5 CPCS PDUs are provided to further system components, which ultimately provide the received data from the ATM cells to an application on the receiving node.

The node also performs a CRC check on the received AAL5 CPCS PDU. The CRC value is calculated by a transmitter, often by a segmentation module 17, before the AAL5 CPCS PDU is sent. The CRC value is checked by the receiver when the AAL5 CPCS PDU is received. In one embodiment, a difference in the CRC value calculated by the segmentation module and the reassembly module indicates that there was an error during transmission of the payload.

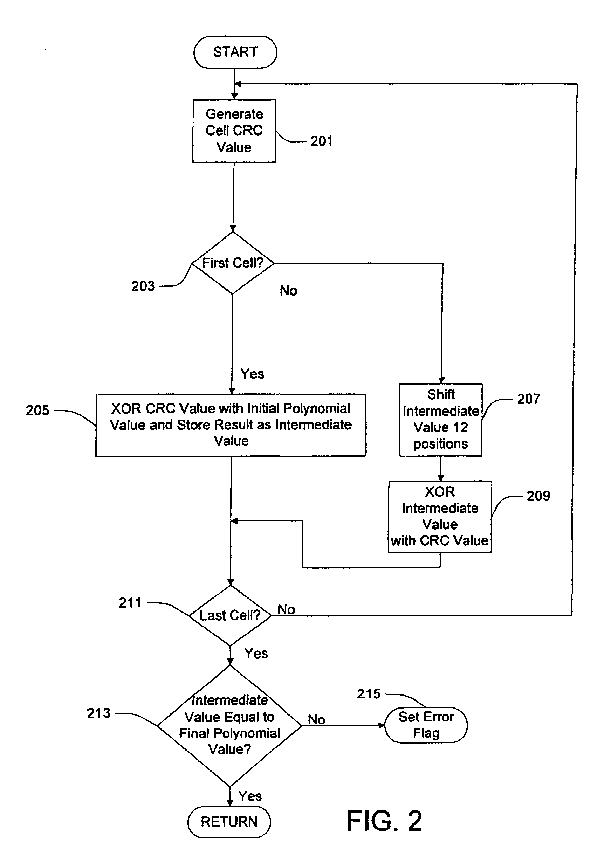

A flow diagram of one embodiment of a process for performing the CRC check is shown in FIG. 2. In one embodiment, the process is implemented in hardware, and those of skill in the art will recognize how to transform the process of FIG. 2 into circuit elements either manually or using an HDL such as VHDL or Verilog. Briefly, the process manipulates ATM cells upon receipt, and maintains an intermediate value for each PDL to allow for CRC checking.

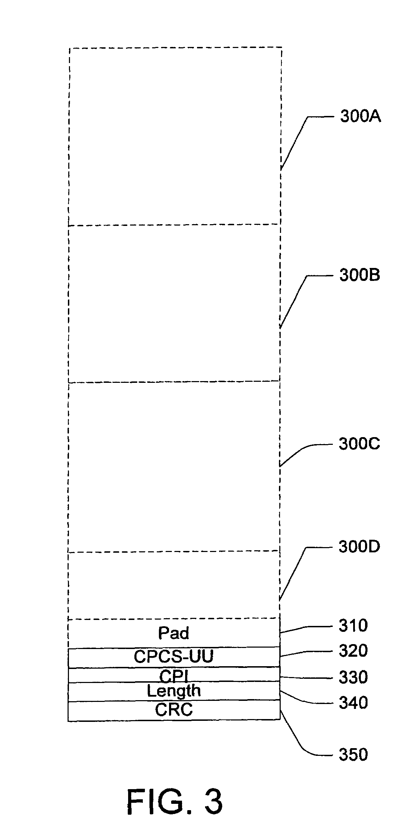

To assist in the understanding of the present invention, FIG. 3 illustrates an exemplary AAL5 CPCS PDU. The AAL5 CPCS PDU is broken into cells. As illustrated, the AAL5 CPCS PDU includes four cells 300A-D. Although only four cells are illustrated, actual AAL5 CPCS PDU may vary in the number of cells.

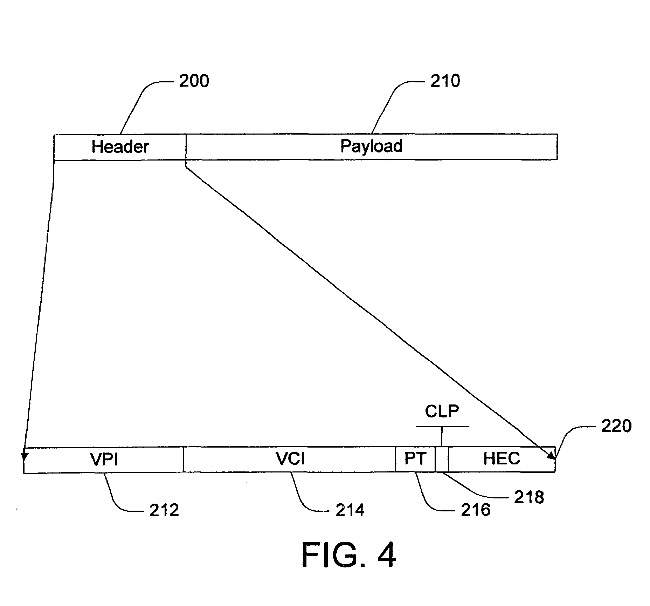

Referring now also to FIG. 4, each of the cells, e.g., cells 300A-D, includes a header portion 200 and a payload portion 210. The header portion is comprised of five bytes and the payload portion is comprised of 48 bytes of data. The header portion provides routing information used by the ATM layer to route ATM cells through the ATM network. The payload portion comprises user data and AAL5 layer data.

The header portion for ATM cells used within a Network-to-Network Interface (NNI) is comprised of a Virtual Path Identifier (VPI) field 212, a Virtual Circuit Identifier (VCI) field 214, a Payload Type (PT) identifier field 216, a Cell Loss Priority (CLP) field 218, and a Header Error Control (HEC) field 220. The VPI field is 12 bits in length and is used in conjunction with the VCI field to define a routing path through the physical layer. The VCI field is 16 bits in length. During transmission of a PDU, the VPI/VCI pair is assumed to be unique. The PT identifier field is 3 bits in length and the FT identifier field describes the payload type. The PT identifier field is also used to signify that a cell is the last cell in a PDU. Accordingly, through tracking of VPI/VCI pairs and through examination of the PT identifier field, the receiver may determine when reception of cells for a PDU beings and ends. The CLP field is 1 bit in length and signals whether or not the ATM cell should be dropped during times of network congestion. The HEC field is 8 bits in length and is used by the physical layer for detecting ATM cell transmission errors.

The last cell, e.g., cell 300D, includes at most 40 bytes of payload data and 8 bytes of additional information at the end of the payload. If less than 40 bytes of payload data are available, then the last cell is padded with a pad field 310 to allow for a properly sized ATM cell. The last 8 bytes include a CPCS User-to-User (CPCS-UU) field 320, a Common Part Indicator (CPI) field 330, a length field (340), and a Cyclic Redundancy Check (CRC) field 350.

The CPCS-UU field comprises data used for user-to-user information. Its content is not specified for the AAL5 CPCS PDU format. The size of the CPCS-UU field is one byte. The length field 340 comprises a binary representation of the length of the payload field in bytes. The size of the length field is two bytes. The CRC field comprises a binary representation of a CRC value calculated over the entire payload field. The size of the CRC field is 4 bytes.

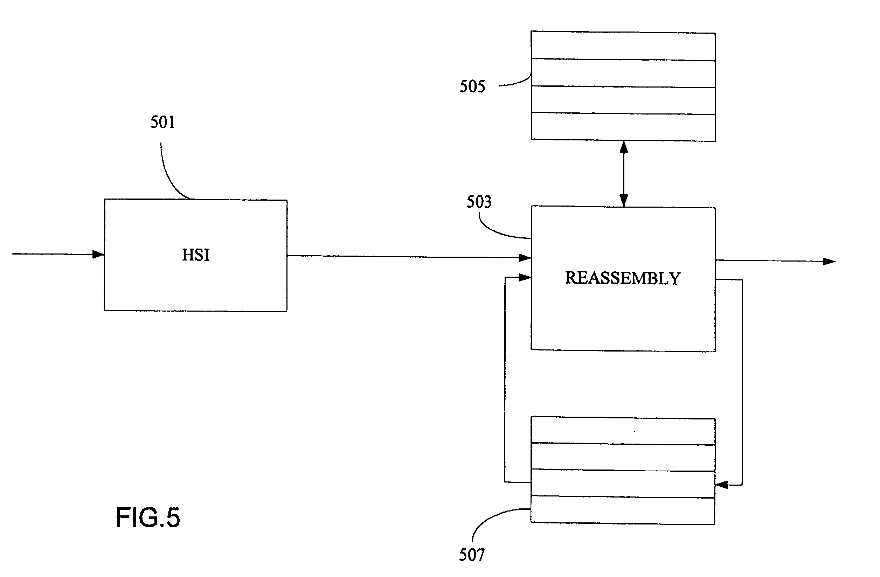

Returning to the process of FIG. 2, in Block 201, cell CRC values are generated on a cell by cell basis upon reception. A cell CRC value is calculated for each cell on receipt. The cell CRC value is calculated using "100000100110000C10001110110110111" or in polynomial notation, x³² + x²⁶ + x²³ + x²² + x¹⁶ + x¹² + x¹¹ + x¹⁰ + x⁸ + x⁷ + x⁵ + x⁴ + x² + x¹ + x⁰, i.e., the CRC-32, and by loading all zeros in a CRC 32 register. In the embodiment of FIG. 5, this calculation is performed in the HSI module 501. The HSI module includes an XOR tree for performing the calculation. Such XOR trees are known in the art. In an alternative embodiment, a linear shift feedback register (LSFR) is used by the HIS module to perform the cell CRC value calculation.

Referring back to FIG. 2, in Block 203, the process determines if the first ATM cell payload of an AAL5 CPCS PDU is being processed. In one embodiment, for example, the VPI/VCI fields are examined to determine if any PDU's currently being received have such a VPI/VCI value. Thus, VPI/VCI values may be stored in a table suitable for searching, with values cleared when end of message indications, such as indicated by the PT identifier field, are received.

If the process determines that the first ATM cell payload is being processed, the process combines the cell CRC value with an initial polynomial value in block 205. In one embodiment, the initial polynomial value in binary is "0101011000100101110111010110000" which in polynomial notation is x³⁰ + x²⁸ + x²⁶ + x²⁵ + x²¹ + x²⁰ + x¹⁷ + x¹⁵ + x¹⁴ + x¹³ + x¹¹ + x¹⁰ + x⁹ + x⁷ + x⁵ + x⁴. In the embodiment of FIG. 1, this is accomplished by the reassembly module or component, with the operation being performed using an XOR tree. In an alternative embodiment, an LSFR is used to perform the operation. The resulting value is stored as an intermediate value for further processing.

If the process is processing an ATM cell payload other than the first ATM cell payload of an AAL5 CPCS PDU, then the intermediate value previously determined is shifted for 12 cycles in Block 207, and the shifted intermediate value is combined with the cell CRC value calculated for the ATM cell payload in an XOR operation in Block 209. In one embodiment this is accomplished in the reassembly component, using the XOR tree used by the reassembly component for the previously described XOR calculation. Moreover, in one embodiment, shifting of the intermediate value is accomplished by appropriately routing the intermediate value bits into appropriate locations in the XOR tree. Thus, in one embodiment, multiplexers are used to route either bits of the initial polynomial value and/or bits of the intermediate value into the XOR tree.

If the process, in block 211, determines that the last ATM cell payload of a AAL5 CPCS PDU has not been reached, then the process continues back to block 201 and processes the incoming ATM payloads until the last ATM cell payload is reached.

If the process determines that the last ATM cell payload has been processed, then the process compares the intermediate value to a final polynomial value in Block 213. If the intermediate value and final polynomial values are not equal, then an error flag is set in block 215. The final polynomial value in binary is "11000111000001001101110101111011" and in polynomial notation is x³¹ + x³⁰ + x²⁶ + x²⁵ + x²⁴ + x¹⁸ + x¹⁵ + x¹⁴ + x¹² + x¹¹ + x¹⁰ + x⁸ + x⁶ + x⁵ + x⁴ + x³ + x¹ + x⁰.

FIG. 5 illustrates one embodiment of a block diagram of a system for performing operations in accordance with the process of FIG. 2. The system of FIG. 5 includes a cell reception module or HSI 501. The cell reception module receives incoming cells and calculates a cell CRC value for each cell. The cell and the cell CRC value are provided to a reassembly component 503. The reassembly component examines the VPI/VCI pair for the cell and compares the pair with a table 505. If the VPI/VCI pair is not in the table, then the reassembly component adds the VPI/VCI pair to the table and calculates an initial intermediate value. The initial intermediate value is stored in a slot of a table of intermediate values 507 corresponding to the slot or location of the placement of the VPI/VCI pair in the table of currently received PDUs.

If the VPI/VCI pair is in the table, and the cell is not the last cell of the PDU, as indicated by the PT identifier field, then the reassembly component retrieves the appropriate intermediate value from the table of intermediate values and calculates a new intermediate value as previously described above. The new intermediate value is then stored in the appropriate location in the table of intermediate values.

If, however, the VPI/VCI pair is in the table and the PT identifier field indicates the end of the PDU, then final processing occurs. The reassembly component clears the VPI/VCI pair from the table and calculates a final CRC value as previously described above. The final CRC value is compared with a constant value, and if the values do not match, an error flag is set.

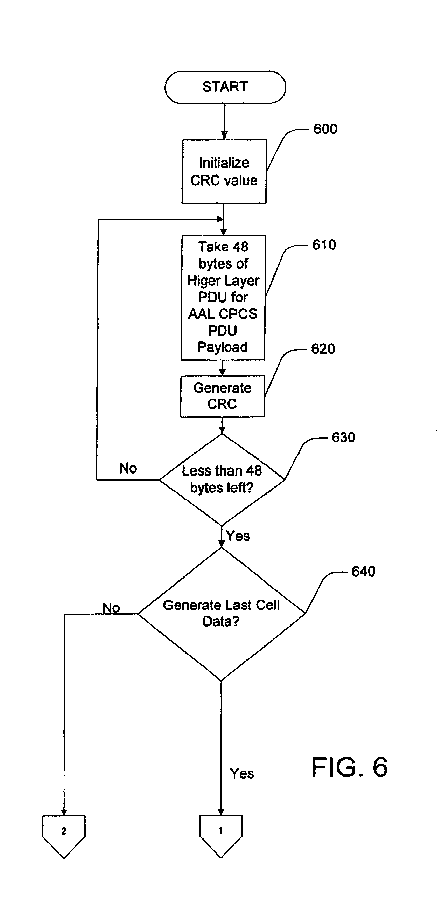

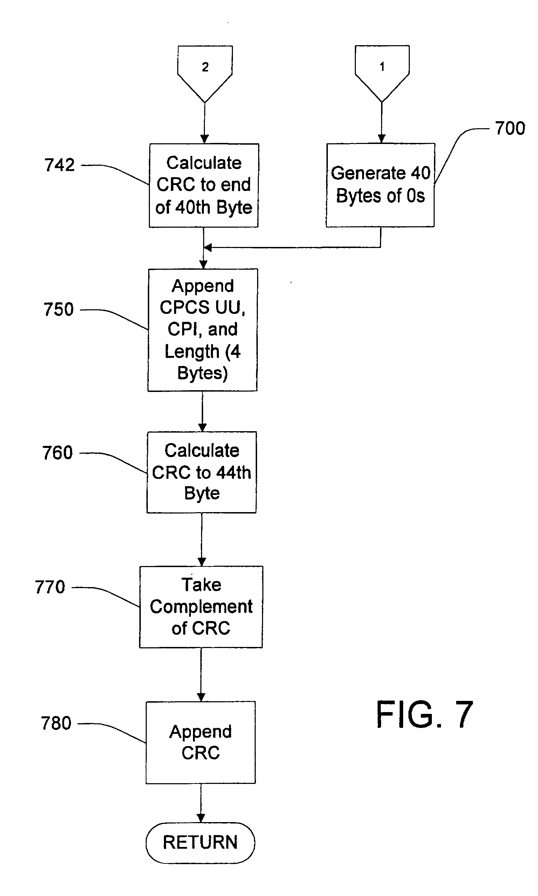

FIGS. 6 and 7 are process flow diagrams of an exemplary process for calculating a CRC value while segmenting a higher layer PDU into an AAL5 CPCS PDU. The exemplary process for calculating a CRC value can be used by a segmentation component 17 (FIG. 1) within the SAR. The process initializes a CRC value in block 600. In one embodiment, the CRC value is initialized with all "1"s. The process reads a first ATM cell payload of 48 bytes of the higher layer PDU in block 610. The process generates a CRC value in block 620 for the 48 byte ATM cell payload. In one embodiment, the polynomial value in binary is "100000100110000010001110110110111" or in polynomial form x³² + x²⁶ + x²³ + x²² + x¹⁶ + x¹² + x¹¹ + x¹⁰ + x⁸ + x⁷ + x⁵ + x⁴ + x² + x¹ + x⁰ that has a width of 32. This polynomial value is termed the CRC32 polynomial. If the process determines that 48 bytes or more of the higher layer PDU remain to be processed in block 630, the process repeats continuing back to block 610, so that an additional 48 byte ATM cell payload is read and the CRC value is regenerated until less than 48 bytes remain to be processed from the higher layer PDU.

If the segmentation component is to create a last cell as a pad for the AAL5 CSPC PDU, then the process creates, in block 700, 40 bytes of zero data and appends the previously described CPCS-UU, CPI, and payload length values in block 750. The process then continues to calculate the CRC value on the last cell of the payload but stops calculating the CRC value at the 44^{th} byte, in block 760. The process complements the CRC value in block 770 and appends the CRC value in block 780 as the last field in the trailer of the AALS CPCS PDU.

Alternatively, the higher layer PDU may contain enough data to create a last cell using the data from the higher layer PDU. If so, the process calculates the CRC value until the end of the 40^{th} byte of the last cell in block 742 and appends the previously described CPCS-UU, CPI, and payload length values in block 750. The process then continues to calculate the CRC value on the last cell of the payload but stops calculating the CRC at the 44^{th} byte in block 760. The CRC value is then complemented by the process in block 770 and is appended, in block 780, as the last field in the trailer of the AAL5 CPCS PDU.

Although this invention has been described in certain specific embodiments, many additional modifications and variations would be apparent to those skilled in the art. It is therefore to be understood that this invention may be practiced otherwise than as specifically described. Thus, the present embodiments of the invention should be considered in all respects as illustrative and not restrictive, the scope of the invention to be determined by any claims supportable by this application and the claims' equivalents rather than the foregoing description.

## Claims

1. A method of detecting transmission errors in a data packet segmented into a set of cells, comprising:
initializing a memory location with a first value;
generating a first cell CRC value;
replacing the first value in the memory location with an intermediate value generated from the first value and the first cell CRC value;
generating a cell CRC value;
shifting the intermediate value in the memory location; and
replacing the shifted intermediate value in the memory location with an intermediate value generated from the shifted intermediate value and the cell CRC value;
iteratively repeating generating a cell CRC value, shifting the intermediate value in the memory location, and replacing the shifted intermediate value in the memory location with an intermediate value generated from the shifted intermediate value and the cell CRC value until a last cell is detected; and
comparing the intermediate value in the memory location with an end comparison value.

2. The method of Claim 1, wherein the first value in polynomial notation is x³⁰ + x²⁸ + x²⁶ + x²⁵ + x²¹ + x²⁰ + x¹⁷ + x¹⁵ + x¹⁴ + x¹³ + x¹¹ + x¹⁰ + x⁹ + x⁷ + x⁵ + x⁴.

3. The method of Claim 2, wherein the intermediate value is generated by XORing the first value and the first cell CRC value.

4. The method of Claim 3, wherein the subsequent intermediate values are generated by XORing the shifted intermediate value and the cell CRC value.

5. The method of Claim 4, wherein the intermediate value is shifted twelve times.

6. The method of Claim 5, wherein the polynomial used for the first cell CRC value in polynomial notation is x³² + x²⁶ + x²³ + x²² + x¹⁶ + x¹² + x¹¹ + x¹⁰ + x⁸ + x⁷ + x⁵ + x⁴ + x² x¹ + x⁰.

7. The method of Claim 6, wherein the end comparison value in polynomial notation is x³¹ + x³⁰ + x²⁶ + x²⁵ + x²⁴ + x¹⁸ + x¹⁵ + x¹⁴ + x¹² + x¹¹ + x¹⁰ + x⁸ + x⁶ + x⁵ + x⁴ + x³ + x¹ + x⁰.

8. An error detection apparatus comprising:
high speed interface calculating a cyclic redundancy check value for incoming data;
segmentation module dividing higher layer cells into lower layer cells and calculating intermediate CRC values for each lower layer cell.

9. The apparatus of claim 8 further comprising a register and wherein the high speed interface initializes the register with a predetermined value.

10. The apparatus of claim 9 wherein the register is initialized by loading the register with all ones.

11. The apparatus of claim 10 wherein the high speed interface generates a cell CRC value for each lower layer cell.

12. The apparatus of claim 11 wherein the segmentation module calculates the intermediate CRC values by applying contents of the register to a generated cell CRC value to formulate a resultant value and replacing the contents with the resultant value until a last cell is detected.

13. The apparatus of claim 12 wherein the contents of the register are XORed with the generated cell CRC value.

14. The apparatus of claim 8 further comprising reassembly module generating higher layer cells from lower layer cells and calculating intermediate CRC values for each of the lower layer cells.

15. The apparatus of claim 14 wherein the register is initialized by loading the register with all zeros.

16. The apparatus of claim 15 wherein the high speed interface generates a cell CRC value for each lower layer cell.

17. The apparatus of claim 16 wherein the reassembly module calculates a first intermediate CRC value by applying contents of the register to a predetermined CRC value to formulate a first resultant value and replacing the contents with the first resultant value.

18. The apparatus of claim 17 wherein the predetermined CRC value in polynomial notation is x³⁰ + x²⁸ + x²⁶ + x²⁵ + x²¹ + x²⁰ + x¹⁷ + x¹⁵ + x¹⁴ + x¹³ + x¹¹ + x¹⁰ + x⁹ + x⁷ + x⁵ + x⁴.

19. The apparatus of claim 17 wherein the reassembly module calculates the intermediate CRC values by shifting contents in the register, applying the contents to a generated cell CRC value to formulate a resultant value and replacing the contents with the resultant value until a last cell is detected.

20. The apparatus of claim 19 wherein the contents of the register are XORed with the generated cell CRC value.

21. The apparatus of claim 19 wherein the reassembly module compares a final CRC value to a predetermined final CRC value.

22. The apparatus of claim 21 wherein the final CRC value is an intermediate CRC value for a lower layer cell that proceeds a last lower layer cell.

23. The apparatus of claim 21 wherein the contents in the register is shifted twelve times.

24. The apparatus of claim 22 wherein the predetermined final CRC value in polynomial notation is x³¹ + x³⁰ + x²⁶ + x²⁵ + x²⁴ + x¹⁸ + x¹⁵ + x¹⁴ + x¹² + x¹¹ + x¹⁰ + x⁸ + x⁶ + x⁵ + x⁴ + x³ + x¹ + x⁰

25. The apparatus of claim 13 wherein the segmentation module, when a last extra cell is generated, calculates a last CRC value over all bytes of the last extra cell.

26. The apparatus of claim 25 wherein the segmentation module, when a last cell is generated, appends a trailer to the last cell and calculates a last CRC value over the bytes in the last cell including the trailer.

27. The apparatus of claim 26 wherein the segmentation module complements the last CRC value and appends the last CRC value to the last cell.
